## Europäisches Patentamt

## European Patent Office

## Office européen des brevets

(19)

(11) Veröffentlichungsnummer: **0 097 850**
**B1**

(12) # EUROPÄISCHE PATENTSCHRIFT

(45) Veröffentlichungstag der Patentschrift:
26.02.86

(51) Int. Cl.⁴: **H 01 L 29/82**

(21) Anmeldenummer: 83105641.1

(22) Anmeldetag: 09.06.83

(54) **Magnetfeldsensor.**

(30) Priorität: 15.06.82 CH 3679/82

(43) Veröffentlichungstag der Anmeldung:
11.01.84 Patentblatt 84/2

(45) Bekanntmachung des Hinweises auf die Patenterteilung:
26.02.86 Patentblatt 86/9

(84) Benannte Vertragsstaaten:
DE FR GB IT NL SE

(56) Entgegenhaltungen:
DE - A - 2 918 483
DE - A - 2 948 762
DE - A - 3 008 308
DE - A - 3 133 908
DE - A - 3 140 544
FR - A - 2 035 947
FR - A - 2 093 591
FR - A - 2 139 178
US - A - 4 240 059

(73) Patentinhaber: **LGZ LANDIS & GYR ZUG AG,**
**CH-6301 Zug (CH)**

(72) Erfinder: **Popovic, Radivoje, Zugerstrasse 24,**
**CH-6312 Steinhausen (CH)**
Erfinder: **Baltes, Heinrich Peter, University of Alberta,**
**Edmonton Alberta (CA)**

(74) Vertreter: **Müller, Hans-Jürgen, Dipl.-Ing. et al, Müller,**
**Schupfner & Gauger**
**Lucile-Grahn-Strasse 38 Postfach 80 13 69,**
**D-8000 München 80 (DE)**

LIBER, STOCKHOLM 1986

## Beschreibung

### Anwendungsgebiet und Zweck

Die Erfindung bezieht sich auf einen Magnetfeldsensor gemäss dem Oberbegriff des Anspruchs 1. Ein derartiger Magnetfeldsensor ist aus der FR-A- 2 093 591 bekannt.

### Stand der Technik

Aus "IEEE Transactions on electron devices", Vol. ED—28, No. 3, März 81, Seiten 237 bis 241, "Double-Injection phenomena under magnetic field in SOS films...", Azar Mohaghegh et al, ist eine Silizium-Magnetodiode in "Silicon on sapphire (SOS)"-Technologie bekannt.

Der wichtigste Faktor bei einer Magnetodiode ist das Vorhandensein zweier Grenzflächen mit stark unterschiedlichen Rekombinationsraten. Die Grenzfläche mit einer hohen Rekombinationsrate ist in integrierten Schaltungen sehr schwer mit reproduzierbaren Eigenschaften herzustellen und verlangt eine weniger gebräuchliche Herstellungs-Technologie, z.B. die erwähnte SOS-Technologie. Die letztere ist jedoch teuer und nicht breit gestreut erhältlich. Bei ihr besteht die eine hohe Rekombinationsrate aufweisende Grenzfläche aus einem $Si/Al_2O_3$-Uebergang.

### Aufgabe und Lösung

Der Erfindung liegt die Aufgabe zugrunde, einen aus einer bipolaren Silizium-Magnetodiode bestehenden Magnetfeldsensor zu schaffen, zu dessen Herstellung nur eine herkömmliche Standard"Bulk Silicon"-Technologie benötigt wird, und dessen Empfindlichkei.t gross ist und in der Grössenordnung von z.B. mindestens 5 Volt/Tesla liegt.

Die genannte Aufgabe wird erfindungsgemäss durch die im Kennzeichen des Anspruchs 1 angegebenen Merkmale gelöst.

Ein Ausführungsbeispiel der Erfindung ist in der Zeichnung dargestellt und wird im folgenden näher beschrieben.

Es zeigen: Fig. 1 Eine Draufsicht der Grundstruktur einer Silizium-Magnetodiode, Fig. 2 einen Querschnitt der Grundstruktur einer Silizium-Magnetodiode, Fig. 3 ein optimales Dotierungsprofil einer Basiswanne, Fig. 4 einen Querschnitt der Grundstruktur einer Silizium-Magnetodiode zur Erläuterung von deren Funktion, Fig. 5 eine Darstellung des aktiven Gebietes einer Silizium-Magnetodiode, Fig. 6 eine Darstellung des aktiven Gebietes eines bipolaren NPN-Transistors, Fig. 7 ein Schaltbild mit einer Silizium-Magnetodiode, Fig. 8 ein Schaltbild mit einem bipolaren NPN-Transistor, Fig. 9 eine Draufsicht einer Silizium-Magnetodiode mit Schutzzone, Fig. 10 einen Querschnitt einer Silizium-Magnetodiode mit Schutzzone, Fig. 11 eine Draufsicht einer Silizium-Magnetodiode mit Schottky-Metallkontakt, Fig. 12 einen Querschnitt einer Silizium-Magnetodiode mit Schottky-Metallkontakt und Fig. 13 $U_{BE}/I_B$-Kennlinien einer Silizium-Magnetodiode.

Gleiche Bezugszahlen bezeichnen in allen Figuren der Zeichnung gleiche Teile.

### Beschreibung

In der Fig- 1 sind Ansichten einer in"Bulk silicon"-Technologie hergestellten Si 1izium-Magnetodiode wiedergegeben. Der dargestellte Aufbau ähnelt demjenigen eines bekannten bipolaren NPN-Transistors und besteht aus einem Substrat 1, einer Basiswanne 2, einer Kollektorzone 3, einer Basiszone 4 und einer Emitterzone 5. Das Substrat 1 ist aus N-, die Basiswanne 2 aus P−—, die Kollektor- und die Emitterzone 3 und 5 aus N+- und die Basiszone 4 aus P+ -Material hergestellt. Natürlich kann die Silizium-Magnetodiode auch ähnlich einem bipolaren PNP-Transistor aufgebaut werden. In diesem Fall besteht das Substrat 1 aus P-, die Basiswanne 2 aus N-, die Kollektor- und die Emitterzone 3 und 5 aus P+- und die Basszone 4 aus N+-Material. P+ und N+ bezeichnen dabei stark dotiertes und P- und N- schwach dotiertes P- bzw. N-Material.

Die Basiswanne 2 und die Kollektorzone 3 sind an der Oberfläche in das Substrat 1 hineindiffundiert worden, desgleichen die Basiszone 4 und die Emitterzone 5 an der Oberfläche in die Basiswanne 2. Die drei Zonen 3, 4 und 5 sind je mit einem elektrischen Anschluss versehen, wobei C den Kollektor-, B den Basisund E den Emitteranschluss bezeichnet. Alle drei annähernd rechteckförmigen Zonen 3, 4 und 5 sind räumlich auf einer geraden Linie AA' und symmetrisch zu dieser Linie AA' angeordnet wobei die Basiszone 4 zwischen der Emitter- und der Kollektorzone 3 und 5 liegt. Die ganze Oberfläche des Kristalls der Magnetodiode ist mit Ausnahme der Anschlussdurchführungsstellen mit einer Schutzschicht 8 aus $SiO_2$ bedeckt.

Die Tiefe $x_j$ der Basiswanne 2 ist annähernd 5 μm und diejenigen der Kollektor-, der Basis- und der Emitterzone 3 4 und 5 annähernd 1 μm. Die Resistivität des Substrats 1 besitzt herkömmliche Werte von 1 bis 10 Ω.cm. Die Trägerkonzentration der drei Zonen 3, 4 und 5 ist grösser oder gleich $10^{19} cm^{-3}$ diejenige n der Basiswanne muss dagegen sehr niedrig und gleich oder kleiner als $5.10^{16} cm^{-3}$ bei P- - bzw. gleich oder kleiner als $5.10^{16} cm^{-3}$ bei N- -Material sein. Bei N- -Material kann man vorzugsweise bis herab zu $10^{15} cm^{-3}$

gehen.

Die Grösse des Abstandes zwischen der Basiszone 4 und der Emitterzone 5 ist unkritisch und kann zwischen 10 und 30 μm betragen. Dagegen sollte die Emitterzone 5 nur einen kleinen Raum belegen, um Vertikalinjektionen von Ladungsträgern zu vermeiden.

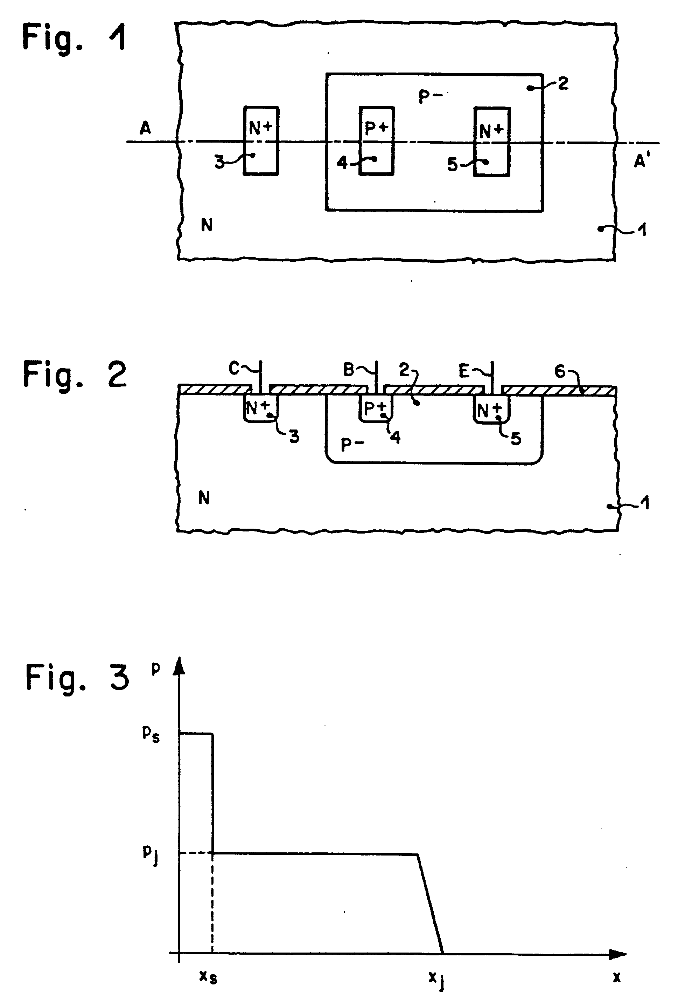

Ein optimales Dotierungsprofil der Basiswanne 2, d.h. ihre Trägerkonzentration p in Funktion des Abstandes x zur Kristalloberfläche, ist in der Fig. 3 dargestellt. Eine hohe, annähernd konstante Oberflächenkonzentration $p_S \leqslant 5.10^{16} cm^{-3}$ und vorzugsweise bedeutend grösser als $5.10^{16} cm^{-3}$ ist in einer dünnen Oberflächenschicht der Dicke $x_S = 0,2$ μm vorhanden, wobei das Produkt $p_S.x_S$ möglichst klein sein sollte, d.h. gerade gross genug, um eine Oberflächeninversion zu vermeiden. Die restliche Tiefe $x_j$ der Basiswanne 2 enthält die bereits erwähnte, ebenfalls annähernd konstante Trägerkonzentration $P_j$. Ein konstanter Wert der Trägerkonzentration wird verwendet, um keine vertikalen elektrischen Felder in den Kristall einzubauen.

Die Fig. 4 entspricht der Fig. 2, nur dass hier noch zusätzlich negative Ladungsträger 7 in der Basiswanne 2, ein senkrecht zur Papierebene wirkendes Magnetfeld 8, eine positive Kollektor/Basis-Spannung $V_C$ und eine negative Emitter/Basis-Spannung $V_E$ dargestellt sind, wobei die Basis B an Masse liegt.

Bedingt durch seine räumliche Anordnung wirkt das Magnetfeld 8 einerseits parallel zur Kristalloberfläche der Magnetodiode und anderseits senkrecht zum elektrischen Strom I, der innerhalb der Basiswanne 2 horizontal von der Basis B zum Emitter E fliesst. Ist der Wert H des Magnetfeldes 8 positiv, d.h. wirkt das Magnetfeld 8 in die Papierebene hinein, so werden die ohne Magnetfeld 8 normalerweise in der Darstellung der Zeichnung horizontal von rechts nach links fliessenden negativen Ladungsträger 7 nach oben hin abgelenkt in Richtung der Schutzschicht 6, d.h. zum Si/SiO2-Uebergang. Ist der Wert H des Magnetfeldes 8 dagegen negativ, d.h. wirkt das Magnetfeld aus der Papierebene heraus, so werden diese negativen Ladungsträger 7 nach unten hin abgelenkt in Richtung der P⁻/N-Grenzschicht zwischen Basiswanne 2 und Substrat 1, die hier als PN-Sperrschicht arbeitet.

Die Schutzschicht 6 wirkt bei einem positiven Magnetfeld 8 genau wie bei der bekannten SOS-Magnetodiode als Grenzfläche mit einer niedrigen Rekombinationsrate. Dagegen besteht die andere, eine hohe Rekombinationsrate aufweisende Grenzfläche hier nicht aus einem Si/Al2O3-Uebergang, sondern aus der PN-Sperrschicht zwischen Basiswanne 2 und Substrat 1. Diese Sperrschicht ist zwar streng genommen keine Rekombinationsfläche, sondern sie wirkt, indem sie die Ladungsträger 7 aufsaugt und so das Vorhandensein einer Grenzfläche mit theoretisch unendlicher Rekombinationsrate simuliert. Da ihre Arbeitsweise nicht auf einem Rekombinationsvorgang, sondern auf einem anderen physikalischen Prinzip beruht, können ihre Eigenschaften reproduzierbar hergestellt werden mit einer herkömmlichen "Bulk silicon"-Technologie. Eine solche Silizium-Magnetodiode besitzt wegen des theoretisch unendlichen Wertes der "Rekombinationsrate" eine sehr hohe Empfindlichkeit in der Grössenordnung von annähernd 5 Volt/Tesla bei einem Speisestrom von 50 mA. Aus dem gleichen Grund sind ihre Kennlinien sehr stabil und besitzt sie eine gute Zuverlässigkeit.

Es können wie bereits erwähnt, mit herkömmlichen Standard-CMOS- und Bipolar-Technologien Grenzflächen mit hohen Rekombinationsraten und reproduzierbaren Eigenschaften nur schwer hergestellt werden, dagegen ist es einfach, solche mit niedrigen Rekombinationsraten, z.B. durch thermisches Oxydieren von Silizium-Oberflächen, zu erzeugen, z.B. zum Erhalt eines Si/SiO2-Ueberganges. Auch können mit diesen Technologien leicht PN-Sperrschichten fabriziert werden.

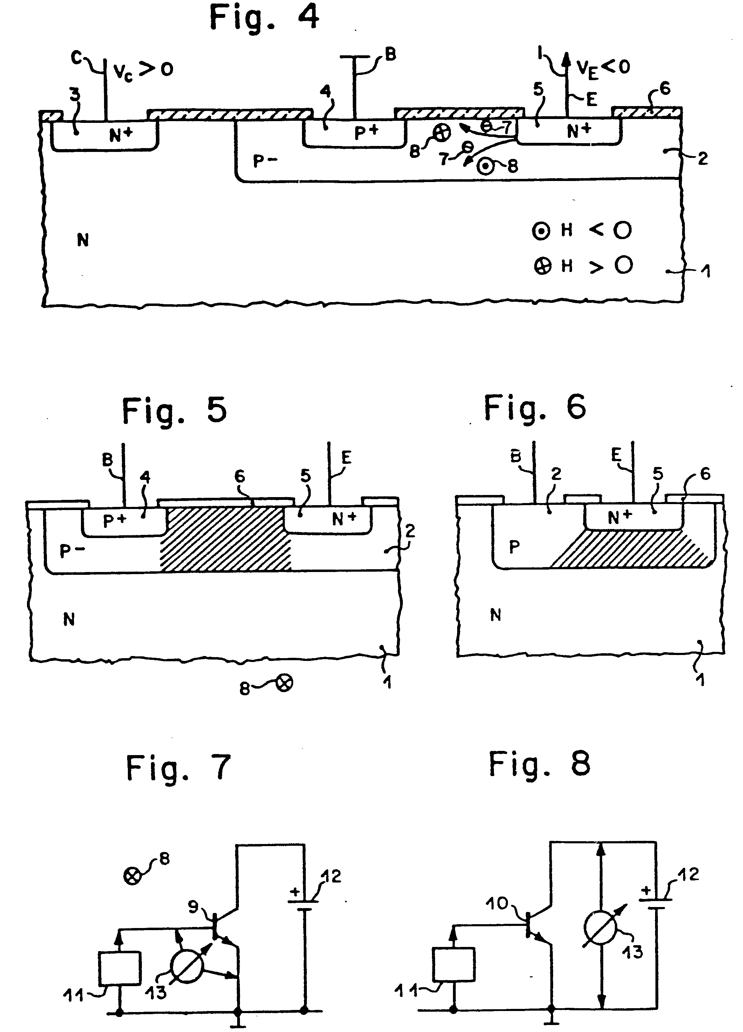

Wie aus der Fig. 1 und der Fig. 2 ersichtlich, ähnelt die Silizium-Magnetodiode im Aufbau einem Bipolar-Transistor. Es gibt jedoch grundsätzliche Unterschiede in der Arbeitsweise. Die Fig. 5 zeigt einen Basis/Emitter-Abschnitt des Querschnittes einer Silizium-Magnetodiode. Das aktive, elektrisch wirksame Gebiet ist in der Fig. 5 und in der nachfolgenden Fig. 6 schraffiert dargestellt und liegt bei der Magnetodiode gemäss der Fig. 5 zwischen der Basiszone 4 und der Emitterzone 5. Bei dem in der Fig. 6 dargestellten Querschnitt eines herkömmlichen bipolaren NPN-Transistors liegt das aktive Gebiet dagegen zwischen dem Substrat 1 und der Emitterzone 5. Die Magnetodiode ist demnach im Grunde genommen ein zweidimensionales und der Bipolar-Transistor ein eindimensionales Gebilde.

Die Basiswanne des NPN-Transistors besteht aus P-Material, dessen Trägerkonzentration mindestens den Wert $10^{18} cm^{-3}$ besitzt, und nicht aus schwach dotiertem P⁻-Material mit einer Trägerkonzentration $\leqslant 5.10^{16} cm^{-3}$. Da es sehr schwer ist, in dem letztgenannten Material einen ohmschen Kontakt für die Basis B einzudiffundieren, wird bei der Silizium-Magnetodiode im Gegensatz zum Bipolar-Transistor noch eine Basiszone 4 aus stack dotiertem, z.B. P⁺-Material benötigt, welche also beim Bipolar-Transistor fehlt.

In der Fig. 7 ist die Beschaltung einer NPN-Silizium-Magnetodiode 9 und in der Fig. 8 diejenige eines NPN-Transistors 10 dargestellt. In diesen beiden Figuren speist eine Strom- bzw. eine Spannungsquelle 11 die Basis/Emitter-Strecken und legt eine Batterie 12 eine positive Spannung an den Kollektor der Silizium-Magnetodiode 9 bzw. des NPN-Transistors 10, wobei der Emitter beider Bauelemente an Masse liegt. Der Unterschied in den beiden Schaltungen besteht nun darin, dass als Träger - Spannung, Strom oder Widerstand - des Nutzsignales im Falle des NPN-Transistors 10 die Kollektor/Emitter-Strecke und im Falle der Silizium-Magnetodiode 9 die Basis/Emitter-Strecke wirksam ist. Ein Voltmeter 13 muss z.B. im ersten Fall zwischen dem Kollektor und dem Emitter und im letzten Fall zwischen der Basis und dem Emitter geschaltet werden, wie dies in der Fig. 7 und in der Fig. 8 dargestellt ist.

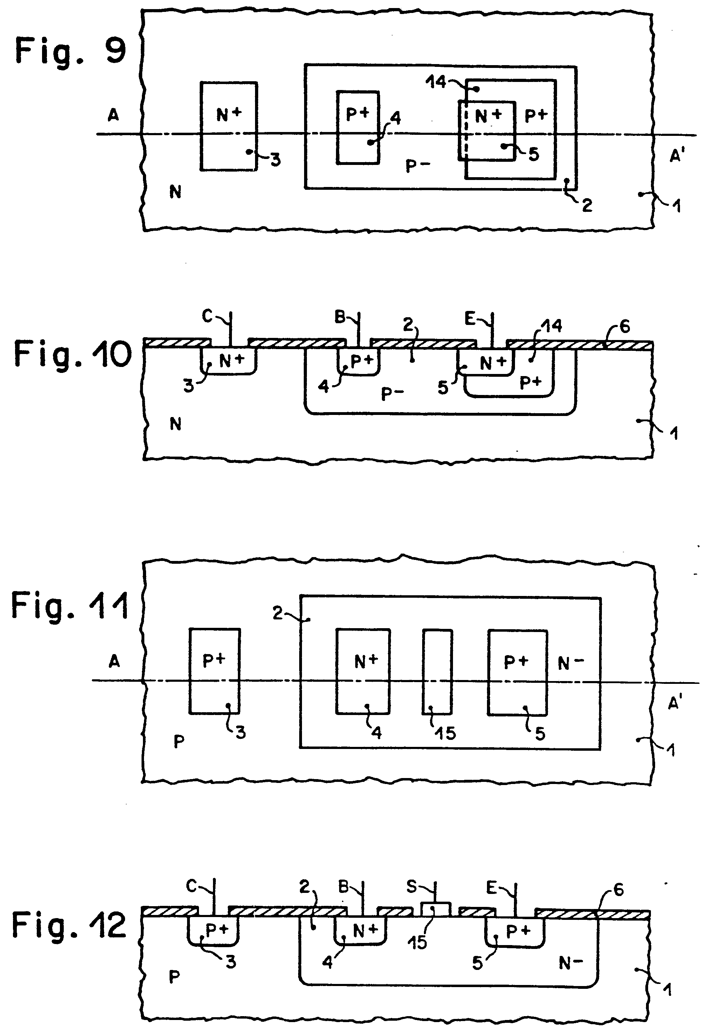

In der Fig. 9 ist eine Draufsicht und in der Fig. 10 ein Querschnitt einer Silizium-Magnetodiode mit Schutzzone dargestellt. Die Fig. 9 entspricht der Fig. 1, und die Fig. 10 der Fig. 2, nur dass in den beiden höher numerierten Figuren die Emitterzone 5 nach allen Seiten von einer Schutzzone 14 umgeben ist, mit Ausnahme der Seiten, die der Basiszone 4 und der Kristalloberfläche der Silizium-Magnetodiode zugewandt sind. Die Schutzzone 14 ist stark dotiert und besteht bei einer NPN-Magnetodiode aus P+-Material. Sie verhindert die Trägerinjizierung von der Emitterzone 5 nach allen Richtungen ausser in Richtung der Basiszone 4. Die Schutzzone 14 besteht dabei aus gleichartigem Material wie die Basiszone 4.

In der Fig. 11 ist eine Draufsicht und in der Fig. 12 ein Querschnitt einer Silizium-Magnetodiode mit Schottky-Metallkontakt 15 wiedergegeben. Die Fig. 11 entspricht der Fig. 1, und die Fig. 12 der Fig. 2, nur dass hier eine PNP- statt eine NPN-Magnetodiode dargestellt ist mit entsprechender Umkehr der Materialtypen, weil es einfacher ist, einen Schottky-Metallkontakt 15 auf N-Material herzustellen. Der an sich bekannte annähernd rechteckförmige Schottky-Metallkontakt, d.h. ein Metall/N-Uebergang im vorliegenden Fall, ist auf der Linie AA' zwischen der Basiszone 4 und der Emitterzone 5 symmetrisch zur Linie AA' angebracht und mit einem Anschluss S als Zusatzelektrode versehen. Die Arbeitsweise und die Beschaltung dieses Schottky-Metallkontaktes 15 ist an sich bekannt und daher hier nicht näher beschrieben.

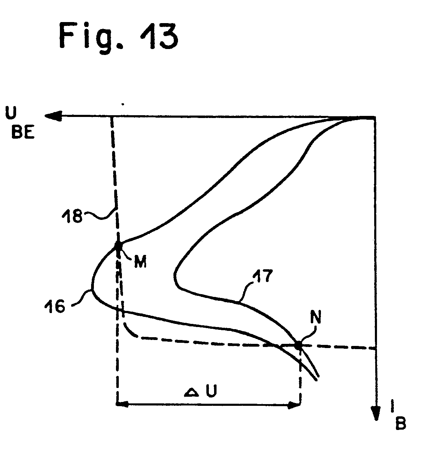

Magnetfeldsensoren der beschriebenen Art besitzen $U_{BE}/I_B$-Kennlinien ähnlich den beiden in der Fig. 13 dargestellten Kennlinien, wobei $U_{BE}$ die Basis/Emitter-Spannung und $I_B$ den Basisstrom des Magnetfeldsensors bezeichnet.

Im annähernd linearen Bereich seiner Kennlinie kann ein Magnetfeldsensor der hier beschriebenen Art z.B. in Elektrizitätszählern als Stromsensor verwendet werden, zum Erfassen des durch einen zu messenden elektrischen Strom erzeugten Magnetfeldes 8. In diesem Fall ist der Magnetfeldsensor Teil des Messwerkes des Elektrizitätszählers.

Die Kennlinien besitzen jedoch auch Kennlinienteile mit einem negativen Widerstandswert, so dass die Silizium-Magnetodioden auch auf bekannte Weise dazu benutzt werden können, Magnetooszillatoren herzustellen und somit ein Teil derselben sind.

Die in der Darstellung der Fig. 13 linke Kennlinie 16 gilt für ein abwesendes und die rechte Kennlinie 17 für ein anwesendes Magnetfeld 8. Wird die Basis B der Silizium-Magnetodiode von einer Stromquelle gespeist, so schneidet deren gestrichelt gezeichnete Kennlinie 18 die linke Kennlinie 16 im Punkt M und die rechte Kennlinie 17 im Punkt N. Der Punkt M ist der Arbeitspunkt der Silizium-Magnetodiode bei nichtvorhandenem und der Punkt N derjenige bei vorhandenem Magnetfeld 8. Die Spannungsdifferenz ΔU zwischen den beiden Arbeitspunkten M und N liegt annähernd in der Grössenordnung von 100 Volt/Tesla und kann dazu verwendet werden, einen nachgeschalteten, von der Basis/Emitter-Spannung der Magnetodiode gesteuerten Halbleiterschalter, z.B. einen bilateralen CMOS-Schalter zu betätigen. Die Magnetodiode und der Halbleiterschalter bilden dann zusammen einen Magnetoschalter, z.B. einen Mikroswitch, der von einem Magnetfeld 8 ein- und ausgeschaltet werden kann. Der Magnetfeldsensor ist dann also ein Teil dieses Magnetoschalters.

Ferner kann die Silizium-Magnetodiode dazu benutzt werden, das Magnetfeld eines Magnet-Domänen-Speichers hoher Dichte zu detektieren. In diesem Fall ist der Magnetfeldsensor Teil des Lesekopfs eines Magnetspeichersystems. Wegen des begrenzten magnetfeldempfindlichen Volumens (schraffiert in Fig. 5) ist eine räumliche Auflösung von bis zu einigen μm erreichbar.

Die bisher beschriebenen Magnetfeldsensoren können als Strom-Messwandler am Eingang von Elektrizitätszählern eingesetzt werden zum Messen des verbrauchten elektrischen Stromes. Dieser Strom-Messwert dient dann anschliessend in Zusammenhang mit einem Spannungs-Messwert zur Ermittlung der verbrauchten elektrischen Energie.

Es gibt grundsätzlich zwei Varianten A und B, solche Elektrizitätszähler elektronisch zu realisieren.

Die Variante A ist in der DE-A- 29 48 762 (= GB-OS 20 64 140) beschrieben. In dieser Variante A wird das vom verbrauchten und zu messenden Strom erzeugte Magnetfeld mit Hilfe eines Referenz-Magnetfeldes abgetastet und die Nullwerte der Differenz beider Magnetfelder elektronisch ausgewertet. Das Referenz-Magnetfeld ist z.B. sägezahnförmig und wird z.B. mittels eines Referenzstromes erzeugt. Der Referenzstrom und der verbrauchte zu messende Strom durchfliessen je eine auf die Oberfläche des Magnetfeldsensors aufgetragene Flachspule oder je einen Flachleiter, der in der Nähe der Oberfläche des Magnetfeldsensors und parallel zu dieser angeordnet ist. Der Flachleiter kann auch U-förmig gebogen sein und den in einem Gehäuse montierten Magnetfeldsensor U-förmig umgeben.

Die Variante B ist in der DE-A- 31 33 908 (= US-Anmeldenummer 06/332.215) beschrieben. In dieser Variante B wird das vom verbrauchten und zu messenden Strom erzeugte Magnetfeld mit Hilfe eines Kompensationsmagnetfeldes kompensiert und ein dieses Kompensationsmagnetfeld erzeugender Kompensationsstrom, der von einem Regelkreis geliefert wird, anschliessend elektronisch ausgewertet. Zur Erzeugung der zugehörigen Magnetfelder durchfliessen der zu messende Strom und der Kompensationsstrom je einen Flachleiter, der in der Nähe der Oberfläche des Magnetfeldsensors angeordnet ist, oder je eine Flachspule, die auf die Oberfläche des Magnetfeldsensors aufgetragen ist. In einer bevorzugten Anordnung sind auch hier die Flachleiter U-förmig gebogen und umgeben den in einem Gehäuse montierten Magnetfeldsensor U-förmig.

In allen Varianten sind die benötigten elektronischen Schaltungen vorzugsweise in dem gleichen Substrat integriert, in das auch der Magnetfeldsensor integriert ist, so dass im Idealfall nur eine einzige gemeinsame integrierte Schaltung vorhanden ist.

Zwecks Verdichtung der Magnetfelder wird das den Magnetfeldsensor enthaltene Substrat in bevorzugten Anordnungen im oder in der unmittelbaren Nähe vom Luftspalt eines Magnetkernes mit seiner Oberfläche parallel zu den Magnetfeldern angeordnet, z.B. gemäss einer der in der DE-A- 29 18 483 ( = US-PS 43 62 990) beschriebenen Montagemethoden. In diesen Fällen genügt es, ein dort verwendetes Substrat mit darauf montiertem Magnetfilm durch den Magnetfeldsensor zu ersetzen.

Bisher wurde angenommen, dass der gesamte verbrauchte Strom im Magnetfeldsensor gemessen wird. Ist dieser Strom jedoch sehr gross, genügt es, einen konstanten und bekannten Bruchteil dieses Stromes dem Magnetfeldsensor in Form eines Magnetfeldes zuzuführen.

Dies geschieht nach einer der drei nachfolgenden Methoden:

Bei einer ersten, unter anderem in der DE-A- 30 08 308 ( = GB-PS 20 50 070) beschriebenen Methode mit Stromteiler wird ein Teil des zu messenden Stromes mit Hilfe eines Shunts vom Magnetfeldsensor ferngehalten.

Bei einer zweiten, in der US-A- 42 40 059 beschriebenen Brücken-Methode, wird der zu messende Strom einer Messbrücke dermassen zugeführt, dass nur der im Diagonalzweig der Messbrücke fliessende Teil des zu messenden Stromes den Magnetfeldsensor erreicht und von diesen, ausgewertet wird.

Eine dritte, in der Internationalen Patentanmeldung WO 83/01 535 beschriebene Methode sieht vor, den zu messenden Strom einem Stromwandler zuzuführen, dessen Primärwicklung aus zwei gegensinnig von Strömen durchf lossenen und annähernd gleiche Widerstände aufweisenden Leitern besteht.

**Patentansprüche**

1. Magnetfeldsensor, bestehend aus einer bipolaren Silizium-Magnetodiode, dessen erste eine niedrige Rekombinationsrate aufweisende, seiner Oberfläche benachbarte Grenzfläche aus einem Si/SiO$_2$-Uebergang besteht, dessen zweite eine hohe Rekombinationsrate simulierende Grenzfläche aus einer PN-Sperrschicht besteht und dessen Basiswanne (2) eine Trägerkonzentration besitzt, die relativ niedrig und gleich oder kleiner 5.10$^{16}$cm$^{-3}$ ist, dadurch gekennzeichnet, dass die Trägerkonzentration $p_S$ einer dünnen Oberflächenschicht der Dicke $x_S$ seiner Basiswanne (2) bedeutend grösser als 5.10$^{16}$cm$^{-3}$ ist und dass das Produkt $p_S.x_S$ gerade gross genug ist, um eine Oberflächeninversion zu vermeiden.

2. Magnetfeldsensor nach Anspruch 1, dadurch gekennzeichnet, dass seine Emitterzone (5) nach allen Seiten von einer stark dotierten Schutzzone (14) umgeben ist, mit Ausnahme der Seiten, die seiner Basiszone (4) und seiner Kristalloberfläche zugewandt sind, wobei die Schutzzone (14) aus gleichartigem Material besteht wie die Basiszone (4) und dengleichen Leitungstyp wie die Basiszone aufweist.

3. Magnetfeldsensor nach Anspruch 1 oder 2, dadurch gekennzeichnet, dass zwischen dem Emitter (E) und der Basis (B) ein Schottky-Meta llkontakt (15) angeordnet ist.

4. Magnetfeldsensor nach einem der Ansprüche 1 bis 3, dadurch gekennzeichnet, dass er ein Teil eines Messwerkes eines Elektrizitätszählers ist.

5. Magnetfeldsensor nach einem der Ansprüche 1 bis 3, dadurch gekennzeichnet, dass er ein Teil eines Magnetoschalters ist.

6. Magnetfeldsensor nach einem der Ansprüche 1 bis 3, dadurch gekennzeichnet dass er ein Teil eines Magnetooszillators ist.

7. Magnetfeldsensor nach einem der Ansprüche 1 bis 3 dadurch gekennzeichnet, dass er ein Teil eines Lesekopfs für Magnet-Domänen-Speicher ist.

8. Magnetfeldsensor nach Anspruch 4, dadurch gekennzeichnet, dass das vom verbrauchten und zu messenden Strom erzeugte Magnetfeld mit Hilfe eines Referenz-Magnetfeldes abgetastet ist und Nullwerte der Differenz bei der Magnetfelder ausgewertet sind.

9. Magnetfeldsensor nach Anspruch 4, dadurch gekennzeichnet dass das vom verbrauchten und zu messenden Strom erzeugte Magnetfeld mit Hilfe eines Kompensationsmagnetfeldes kompensiert und ein dieses Kompensationsmagnetfeld liefernder Kompensationsstrom anschliessend ausgewertet ist.

10. Magnetfeldsensor nach Anspruch 8 oder 9, dadurch gekennzeichnet, dass alle Magnetfelder mittels Strömen erzeugt sind, die Flachleiter, die in der Nähe der Oberfläche des Magnetfeldsensors und parallel zu dieser angeordnet sind, oder Flachspulen durchfliessen, die auf die Oberfläche des Magnetfeldsensors aufgetragen sind.

11. Magnetfeldsensor nach Anspruch 10, dadurch gekennzeichnet dass die Flachleiter U-förmig gebogen sind und den in einem Gehäuse montierten Magnetfeldsensor U-förmig umgeben.

12. Magnetfeldsensor nach einem der Ansprüche 8 bis 11 dadurch gekennzeichnet, dass alle benötigten elektronischen Schaltungen in dem gleichen Substrat integriert sind, in das auch der Magnetfeldsensor integriert ist.

13. Magnetfeldsensor nach einem der Ansprüche 8 bis 12 dadurch gekennzeichnet, dass das den Magnetfeldsensor enthaltende Substrat im oder in der unmittelbaren Nähe vom Luftspalt eines Magnetkerns mit seiner Oberfläche parallel zu den Magnetfeldern angeordnet ist.

14. Magnetfeldsensor nach einem der Ansprüche 8 bis 13, dadurch gekennzeichnet, dass der zu messende Strom einem Stromtei ler zugeführt ist, so dass ein Teil des zu messenden Stromes mit Hilfe eines Shunts vom Magnetfeldsensor ferngehalten ist.

15. Magnetfeldsensor nach einem der Ansprüche 8 bis 13, dadurch gekennzeichnet, dass der zu messende Strom einer Messbrücke dermassen zugeführt ist, dass nur der im Diagonalzweig der Messbrücke fliessende Teil des zu messenden Stromes den Magnetfeldsensor erreicht.

16. Magnetfeldsensor nach einem der Ansprüche 8 bis 13, dadurch gekennzeichnet, dass der zu messende Strom einem Stromwandler zugeführt ist, dessen Primärwicklung aus zwei gegensinnig von Strömen durchflossenen und annähernd gleiche Widerstände aufweisenden Leitern besteht.

## Claims

1. A magnetic field sensor comprising a bipolar silicon magnetodiode whose first interface which is adjacent to its surface and which has a low recombination rate comprises an $Si/SiO_2$ junction and whose second interface which simulates a high reocmbination rate comprises a PN-reverse biased layer and whose base well (2) has a carrier oonoentration which is relatively low and equal to or less than $5.10^{16}cm^{-3}$, characterised in that the carrier concentration $p_S$ of a thin surface layer of a thickness $x_S$ ofits base well (2) is significantly greater than $5.10^{16}cm^{-3}$ and that the product $p_S.x_S$ is just large enough to avoid surface inversion.

2. A magnetic field sensor according to claim 1 characterised in that its emitter region (5) is surrounded on all sides by a heavily doped protective region (14), with the exception of the sides which are towards its base region (4) and its crystal surface, wherein the protective region (14) comprises the same kind of material as the base region (4) and is of the same oonductivity type as the base region.

3. A magnetic field sensor according to claim 1 or claim 2 characterised in that a Schottky metal contact (15) is disposed between the emitter (E) and the base (B).

4. A magnetic field sensor acoording to one of claims 1 to 3 characterised in that it is a part of a measuring mechanism of an electricity meter.

5. A magnetic field sensor according to one of claim 1 to 3 characterised in that it is a part of a magnetically operated switch.

6. A magnetic field sensor according to one of claims 1 to 3 characterised in that it is a part of a magnetooscillator.

7. A magnetic field sensor according to one of claims 1 to 3 characterised in that it is a part of a reading head for magnetic domain memories.

8. A magnetic field sensor according to claim 4 characterised in that the magnetic field generated by the oonsumed current which is to be measured is sensed by means of a reference magnetic field and zero values of the difference between the two magnetic fields are evaluated.

9. A magnetic field sensor according to claim 4 characterised in that the magnetic field generated by the consumed current to be measured is compensated by means of a compensation magnetic field and a compensation current producing said compensation magnetic field is then evaluated.

10. A magnetic field sensor acoording to claim 8 or claim 9 characterised in that all magnetic fields are generated by means of currents which flow through flat conductors disposed in the vicinity of the surface of the magnetic field sensor and in parallel relationship thereto, or flat coils which are applied to the surface of the magnetic field sensor.

11. A magnetic field sensor according to claim 10 characterised in that the flat conductors are of a U-shaped bent configuration and extend in a U-configuration around the magnetic field sensor which is mounted in a housing.

12. A magnetic field sensor according to one of claims 8 to II characterised in that all electronic circuits reguired are integrated in the same substrate in which the magnetic field sensor is also integrated.

13. A magnetic field sensor according to one of claims 8 to 12 characterised in that the substrate containing the magnetic field sensor is disposed in or in the direct vicinity of the air gap of a magnetic core with its surface in parallel relationship with the magnetic fields.

14. A magnetic field sensor acoording to one of claims 8 to 13 characterised in that the current to be measured is fed to a current divider so that a part of the current to be measured is kept away from the magnetic field sensor by means of a shunt.

15. A magnetic field sensor according to one of claims 8 to 13 characterised in that the current to be measured is fed to a measuring bridge in such a way that only the part of the curent to be measured, which flows in the diagonal branch of the measuring bridge, reaches the magnetic field sensor.

16. A magnetic field sensor according to one of claims 8 to 13 characterised in that the current to be measured is fed to a current transformer whose primary winding comprises two conductors which are of approximately equal resistances and which have currents flowing therethrough in opposite directions.


**Revendications**

1. Capteur de champ magnetique, se composant d'une magnétodiode au silicium bipolaire, dont une première surface limite, voisine de sa surface superieure et présentant un faible taux de recombinaison, se composé d'une transition $Si/SiO_2$, dont une seconde surface limite simulant un taux élevé de recombinaison se composé d'une couche d'arrêt PN et dont une cuvette de base (2) présente une concentration en porteurs qui est relativement basse et qui est égale ou inférieure à $5.10^{16}$ cm$^{-3}$, caractérisé en ce que la concentration en porteurs $p_S$ d'une mince couche superficielle de l'épaisseur $x_S$ de sa cuvette de base (2) est considerablement supérieure à $5.10^{16}$ cm$^{-3}$ en ce que le produit $p_S.x_S$ est juste suffisamment grand pour éviter une inversion en surface.

2. Capteur de champ magnétique selon la revendication 1, caractérisé en ce que sa zone d'émetteur (5) est entourée de tout côté par une zone protectrice fortement dopée (14), à l'exception des côtés qui sont tournés vers sa zone de base (4) et sa surface de cristal, la zone protectrice (14) étant constituée d'une matière de même nature que la zone de base (4) et ayant le même type de conductivité que la zone de base (4).

3. Capteur de champ magnétique selon la revendication 1 ou 2, caractérisé en ce qu'il est prévu un contact métallique-Schottky (15) entre l'émetteur (E) et la base (B).

4. Capteur de champ magnétique selon une des revendications 1 à 3, caractérisé en ce qu'il constitué une partie d'un dispositif de mesure d'un compteur d'électricité.

5. Capteur de champ magnétique selon l'une des revendications 1 à 3, caractérisé en ce qu'il constitué une partie d'un magnéto-commutateur.

6. Capteur de champ magnétique selon l'une des revendications 1 à 3, caractérisé en ce qu'il constitué une partie d'un magnéto-oscillateur.

7. Capteur de champ magnétique selon l'une des revendications 1 à 3, caractérisé en ce qu'il constitué une partie d'une tête de lecture d'une mémoire magnétique.

8. Capteur de champ magnétique selon la revendication 4, caractérisé en ce que le champ magnétique produit par un courant consommé et à mesurer est analyse au moyen d'un champ magnétique de référence et en ce qu'on détecte des valeurs d'annulation de la différence des deux champs magnétiques.

9. Capteur de champ magnétique selon la revendication 4, caractérisé en ce que le champ magnétique produit par un courant consommé et à mesurer est compensé à l'aide d'un champ magnétique de compensation et en ce qu'un courant de compensation produisant ce champ magnétique de compensation est ensuite évalué.

10. Capteur de champ magnétique selon la revendication 8 ou 9, caractérisé en ce que tous les champs magnétiques sont produits au moyen de courants qui passent dans des conducteurs plats, qui sont disposés à proximité de la surface du capteur de champ magnétique et parall*élément à celle-ci, ou bien dans des bobines plates qui sont placées sur la surface du capteur de champ magnétique.

11. Capteur de champ magnétique selon la revendication 10, caractérisé en ce que les conducteurs plats sont pliés en forme de U et entourent en forme de U les capteurs de champ magnétique montés dans un boîtier.

12. Capteur de champ magnétique selon l'une des revendications 8 à 11, caractérisé en ce que tous les circuits électroniques nécessaires sont intégrés dans le même substrat, dans lequel est également intégré le capteur de champ magnétique.

13. Capteur de champ magnétique selon l'une des revendications 8 à 12, caractérisé en ce que le substrat contenant le capteur de champ magnétique est disposé dans ou au voisinage immédiat de l'entrefer d'un noyau magnétique, avec sa surface orientée parall*élément aux champs magnétiques.

14. Capteur de champ magnétique selon l'une des revendications 8 à 13, caractérisé en ce que le courant à mesurer est appliqué à un diviseur de courant de manière qu'une partie du courant à mesurer soit maintenue éloignée du capteur de champ magnétique à l'aide d'un shunt.

15. Capteur de champ magnétique selon l'une des revendications 8 à 13, caractérisé en ce que le courant a mesurer est appliqué à un pont de mesure de telle sorte que seulement la partie du courant à mesurer qui passe dans la dérivation en diagonale du pont de mesure parvienne au capteur de champ magnétique.

16. Capteur de champ magnétique selon l'une des revendications 8 à 13, caractérisé en ce que le courant à mesurer est appliqué à un transformateur de courant dont l'enroulement primaire se composé de deux conducteurs ayant approximativement les mêmes résistances et parcourus par des courants en sens inverses.

Fig. 1

Fig. 2

Fig. 3

## Fig. 4

## Fig. 5

## Fig. 6

## Fig. 7

## Fig. 8

Fig. 9

Fig. 10

Fig. 11

Fig. 12

# Fig. 13